# EUROPEAN PATENT APPLICATION

(11) **EP 4 253 868 A1**
(43) Date of publication of application: **04.10.2023**
(21) Application number: 21898017.5
(22) Date of filing: 25.11.2021
(51) Int. Cl.: F25B 9/00, C09K 5/14

(54) **COLD STORAGE MATERIAL, COLD STORAGE MATERIAL PARTICLES, GRANULAR PARTICLES, COLD STORAGE DEVICE, REFRIGERATING MACHINE, CRYOPUMP, SUPERCONDUCTING MAGNET, NUCLEAR MAGNETIC RESONANCE IMAGING APPARATUS, NUCLEAR MAGNETIC RESONANCE APPARATUS, MAGNETIC-FIELD-APPLICATION-TYPE SINGLE CRYSTAL PULLING APPARATUS, AND HELIUM RE-CONDENSATION APPARATUS**

(30) Priority: 26.11.2020 JP 2020195605; 21.07.2021 JP 2021120187
(71) Applicant: KABUSHIKI KAISHA TOSHIBA, Minato-ku Tokyo 105-0023 (JP); Toshiba Materials Co., Ltd., Isogo-Ku Yokohama-Shi Kanagawa 235-0032 (JP)
(72) Inventor: KAWAMOTO, Takahiro, Yokohama-shi Kanagawa 235-0032 (JP); USUI, Daichi, Yokohama-shi, Kanagawa 235-0032 (JP); HIRAMATSU, Ryosuke, Yokohama-shi Kanagawa 235-0032 (JP); KONDO, Hiroyasu, Yokohama-shi Kanagawa 235-0032 (JP); TAGUCHI, Seina, Yokohama-shi Kanagawa 235-0032 (JP)
(74) Representative: Henkel & Partner mbB
(86) International application number: PCT/JP2021/043134
(87) International publication number: WO 2022/114045

(57) **Abstract**

A cold storage material of an embodiment includes a rare earth oxysulfide containing at least one rare earth element selected from the group consisting of Y, La, Ce, Pr, Nd, Sm, Eu, Gd, Tb, Dy, Ho, Er, Tm, Yb, and Lu, and a first group element of 0.001 atom% or more and 10 atom% or less, in which a maximum value of volume specific heat in a temperature range of 2 K or more and 10 K or less is 0.5 J/(cm³·K) or more.

## Description

### TECHNICAL FIELD

Embodiments of the present invention relate to a cold storage material, a cold storage material particle, a granulated particle, a cold storage device, a refrigerator, a cryopump, a superconducting magnet, a nuclear magnetic resonance imaging apparatus, a nuclear magnetic resonance apparatus, a magnetic field application type single crystal pulling apparatus, and a helium re-condensing device.

### BACKGROUND ART

In recent years, development of superconducting technology has been remarkable, and development of a small and high-performance cryogenic refrigerator has become indispensable with expansion of application fields thereof. Such a cryogenic refrigerator is required to be lightweight, compact, and highly thermally efficient, and has been put into practical use in various application fields.

In a cryogenic refrigerator, a plurality of cold storage materials are accommodated in a cold storage device. For example, cold is generated by heat exchange between the cold storage material and helium gas passing through the cold storage device. For example, in a superconducting MRI apparatus, or in a cryopump used in a semiconductor manufacturing apparatus or the like, a refrigerator using a refrigeration cycle such as a Gifford-McMahon (GM) system, a Stirling system, or a pulse tube system is used.

In addition, a high-performance refrigerator is also required for a magnetically levitated train in order to generate a magnetic force using a superconducting magnet. Furthermore, in recent years, a high-performance refrigerator has also been used in a superconducting magnetic energy storage (SMES), a magnetic field application type single crystal pulling apparatus for producing high-quality silicon wafers, and the like. Further, development and practical application of a pulse tube refrigerator, which is expected to have high reliability, are also actively promoted.

In addition, in the superconducting magnet, the MRI apparatus, and the like as described above, since the liquid helium to be used evaporates, the supply of the liquid helium becomes a problem. In recent years, the problem of depletion of helium has become serious, and a difficult state of availability has occurred, affecting the industry.

In order to reduce consumption of the liquid helium and reduce a load of maintenance such as the supply thereof, a helium re-condensing device for re-condensing evaporated helium has been put into practical use, and demand for the helium re-condensing device has increased. In order to liquefy helium, the helium re-condensing device also uses a GM refrigerator or a pulse tube refrigerator that cools the temperature to 4K level.

In such a refrigerator, a working medium such as compressed helium (He) gas flows in one direction in a cold storage device in which a cold storage material is accommodated, and thermal energy thereof is supplied to the cold storage material. Then, the expanded working medium flows in the opposite direction in the cold storage device and receives the thermal energy from the cold storage material. As a recuperating effect in such a process is improved, thermal efficiency in a working medium cycle is improved, and a lower temperature can be realized.

Here, as a specific heat per unit volume of the cold storage material mounted on the cold storage device is higher, the thermal energy that can be stored in the cold storage material increases, so that refrigeration capacity of the refrigerator is improved. Therefore, it is desirable to mount a cold storage material having high specific heat at a low temperature on a low-temperature side of the cold storage device and a cold storage material having high specific heat at a high temperature on a high-temperature side.

A magnetic cold storage material exhibits high volume specific heat in a specific temperature range depending on its composition. Therefore, by combining magnetic cold storage materials having different compositions and exhibiting high volume specific heat in a target temperature range, cold storage capacity is enhanced, and the refrigeration capacity of the refrigerator is improved.

In the cold storage material mounted on the cold storage device, the higher the thermal conductivity and the heat transfer coefficient of the cold storage material, the higher the efficiency of heat energy transfer, and the higher the efficiency of the refrigerator.

In conventional refrigerators, metal cold storage material particles such as lead (Pb), bismuth (Bi), and tin (Sn) are combined on the high temperature side with metal-based magnetic cold storage material particles such as Er₃Ni, ErNi, and HoCu₂ on the low temperature side of 20 K or less to realize freezing at 4 K.

In recent years, attempts have been made to improve the refrigeration capacity of a refrigerator by substituting some of metal-based magnetic cold storage material particles with ceramic magnetic cold storage material particles such as Gd₂O₂S, Tb₂O₂S, Dy₂O₂S, Ho₂O₂S, and GdAlOs having high specific heat in a temperature range of 2 K to 10 K.

As the application of the refrigerator as described above to various cooling systems is studied, the refrigerator is required to further improve the refrigeration capacity of the refrigerator because it is necessary to stably cool a larger cooling target.

### CITATION LIST

### PATENT LITERATURE

Patent Literature 1: JP 2003-73661 A
Patent Literature 2: JP 2003-213252 A
Patent Literature 3: WO 2018/025581 A
Patent Literature 4: Japanese Patent No. 5010071

### SUMMARY OF THE INVENTION

### PROBLEM TO BE SOLVED BY THE INVENTION

An object of the present invention is to provide a cold storage material having high volume specific heat and high thermal conductivity.

### MEANS FOR SOLVING PROBLEM

A cold storage material of an embodiment includes a rare earth oxysulfide containing at least one rare earth element selected from the group consisting of Y, La, Ce, Pr, Nd, Sm, Eu, Gd, Tb, Dy, Ho, Er, Tm, Yb, and Lu, and a first group element of 0.001 atom% or more and 10 atom% or less, in which a maximum value of volume specific heat in a temperature range of 2 K or more and 10 K or less is 0.5 J/(cm³·K) or more.

### BRIEF DESCRIPTION OF THE DRAWINGS

FIG. 1 is a schematic cross-sectional view illustrating a configuration of a main part of a cold storage material particle according to a second embodiment and a refrigerator according to a fourth embodiment.
FIG. 2 is a cross-sectional view illustrating a schematic configuration of a cryopump according to a fifth embodiment.
FIG. 3 is a perspective view illustrating a schematic configuration of a superconducting magnet of a sixth embodiment.
FIG. 4 is a cross-sectional view illustrating a schematic configuration of a nuclear magnetic resonance imaging apparatus of a seventh embodiment.
FIG. 5 is a cross-sectional view illustrating a schematic configuration of a nuclear magnetic resonance apparatus of an eighth embodiment.
FIG. 6 is a perspective view illustrating a schematic configuration of a magnetic field application type single crystal pulling apparatus according to a ninth embodiment.
FIG. 7 is a schematic diagram illustrating a schematic configuration of a helium re-condensing device according to a tenth embodiment.

### EMDODIMENT(S) FOR CARRYING OUT THE INVENTION

Hereinafter, embodiments of the present invention will be described with reference to the drawings. In the following description, the same or similar members and the like are denoted by the same reference numerals, and the description of the members and the like once described may be appropriately omitted.

In the present specification, a cryogenic temperature means, for example, a temperature range in which a superconducting phenomenon can be industrially useful. The cryogenic temperature is, for example, a temperature range of 20 K or less.

### (First Embodiment)

A cold storage material of the first embodiment includes a rare earth oxysulfide containing at least one rare earth element selected from the group consisting of yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), and lutetium (Lu), and a first group element of 0.001 atom% or more and 10 atom% or less, in which a maximum value of volume specific heat in a temperature range of 2 K or more and 10 K or less is 0.5 J/(cm³·K) or more.

The cold storage material of the first embodiment has, for example, volume specific heat of 0.5 J/(cm³·K) or more in a temperature range of 2.5 K or more and 10 K or less. The cold storage material of the first embodiment has, for example, volume specific heat of 0.55 J/(cm³·K) or more in a temperature range of 2 K or more and 8 K or less. The cold storage material of the first embodiment has, for example, volume specific heat of 0.6 J/(cm³·K) or more in a temperature range of 4 K or more and 7 K or less.

The rare earth oxysulfide contained in the cold storage material of the first embodiment is represented by, for example, a general formula R_{2±0.1}O₂S_{1±0.1} (wherein R represents at least one rare earth element selected from the group consisting of Y, La, Ce, Pr, Nd, Sm, Eu, Gd, Tb, Dy, Ho, Er, Tm, Yb, and Lu.). In the rare earth oxysulfide represented by the above general formula, the maximum value of the volume specific heat and the temperature indicating the maximum value of the volume specific heat are different depending on the selected rare earth element. Therefore, specific heat characteristics can be adjusted by appropriately adjusting a proportion of the rare earth element.

The rare earth element is, for example, at least one rare earth element selected from the group consisting of Gd, Tb, Dy, Ho, and Er. The rare earth oxysulfide contained in the cold storage material of the first embodiment may contain, for example, two or more kinds of rare earth elements.

The rare earth oxysulfide is, for example, crystalline.

The cold storage material of the first embodiment contains the rare earth oxysulfide as a main component. Among the substances contained in the cold storage material of the first embodiment, for example, a volume ratio of the rare earth oxysulfide is the largest. Among the substances contained in the cold storage material of the first embodiment, for example, a molar ratio of the rare earth oxysulfide is the largest.

The cold storage material of the first embodiment contains 0.001 atom% or more and 10 atom% or less in total of the first group element. The first group element is at least one element selected from the group consisting of lithium (Li), sodium (Na), potassium (K), rubidium (Rb), cesium (Cs), and francium (Fr). The first group element is, for example, at least one element selected from the group consisting of Li, Na, and K. The cold storage material may contain, for example, two or more kinds of the first group elements.

The first group element contained in the cold storage material is present, for example, in a crystal of the rare earth oxysulfide. The first group element contained in the cold storage material is present, for example, at a crystal grain boundary of the rare earth oxysulfide. The first group element contained in the cold storage material exists, for example, on an inner wall surface of a void existing in the cold storage material. The first group element contained in the cold storage material is present, for example, in crystal grains of the rare earth oxysulfide. The first group element contained in the cold storage material is present, for example, in crystal grains other than the rare earth oxysulfide contained in the cold storage material.

The cold storage material of the first embodiment contains, for example, 0 atom% or more and 10 atom% or less in total of the second group element in addition to the first group element. In addition, the cold storage material of the first embodiment contains, for example, 0.001 atom% or more and 10 atom% or less in total of the second group element in addition to the first group element.

The second group element is at least one element selected from the group consisting of beryllium (Be), magnesium (Mg), calcium (Ca), strontium (Sr), barium (Ba), and radium (Ra). The second group element is, for example, at least one element selected from the group consisting of magnesium (Mg), calcium (Ca), strontium (Sr), and barium (Ba) .

The cold storage material may contain, for example, two or more kinds of second group elements. The cold storage material may not contain the second element.

The second group element contained in the cold storage material is present, for example, in a crystal of the rare earth oxysulfide. The second group element contained in the cold storage material is present, for example, at a crystal grain boundary of the rare earth oxysulfide. The second group element contained in the cold storage material is present, for example, on the inner wall surface of the void present in the cold storage material. The second group element contained in the cold storage material is present, for example, in crystal grains of rare earth oxysulfide. The second group element contained in the cold storage material is present, for example, in crystal grains other than the rare earth oxysulfide contained in the cold storage material.

The cold storage material of the first embodiment contains, for example, a substance derived from a sintering aid used in production of the cold storage material. The sintering aid is, for example, aluminum oxide (alumina), magnesium oxide, yttrium oxide, zirconium oxide, or boron oxide.

The cold storage material of the first embodiment contains, for example, 0.01 atom% or more and 20 atom% or less of at least one element selected from the group consisting of aluminum (Al), iron (Fe), copper (Cu), nickel (Ni), cobalt (Co), zirconium (Zr), and boron (B). The at least one element selected from the group consisting of Al, Fe, Cu, Ni, Co, Zr, and B is, for example, an element derived from the sintering aid.

Note that detection of the element contained in the cold storage material of the first embodiment and measurement of an atomic concentration of the element can also be performed, for example, by dissolving the cold storage material in a liquid and using inductively coupled plasma atomic emission spectroscopy (ICP-AES). It is also possible to use energy dispersive X-ray spectroscopy (EDX) or wavelength dispersive X-ray spectroscopy (WDX).

A crystal structure of the rare earth oxysulfide contained in the cold storage material of the first embodiment is, for example, Ce₂O₂S type, and its space group is P-3m. The crystal structure can be confirmed by powder X-ray diffraction measurement, observation of an electron backscatter diffraction image using a scanning electron microscope, transmission electron microscope observation, or the like.

A method for producing the cold storage material of the first embodiment is not particularly limited, but for example, the cold storage material can be produced by mixing raw material powders using a ball mill or the like to prepare a raw material mixture, and molding and sintering the obtained raw material mixture. As the raw material powder, a rare earth oxide or a rare earth oxysulfide can be used. The type and ratio of the rare earth oxide or the rare earth oxysulfide are adjusted in accordance with a target composition of the cold storage material.

By using a carbonate containing the first group element, an oxide containing the first group element, a nitride containing the first group element, or a carbide containing the first group element in the raw material powder, the first group element can be contained in the cold storage material. By using a carbonate containing the second group element, an oxide containing the second group element, a nitride containing the second group element, or a carbide containing the second group element in the raw material powder, the second group element can be contained in the cold storage material.

The raw material mixture may contain a sintering aid. The sintering aid is, for example, aluminum oxide (alumina), yttrium oxide, zirconium oxide, or boron oxide.

When the rare earth oxide is used as the raw material powder, a molded body is sulfurized. In this case, heat treatment is performed in a sulfurization atmosphere. The sulfurization atmosphere contains, for example, a gas containing a sulfur atom having a negative oxidation number, such as hydrogen sulfide (H₂S), carbon sulfide (CS₂), or methanethiol (CH₃SH). A heat treatment temperature is, for example, 400°C or more and 700°C or less. A heat treatment time is, for example, 1 hour or more and 8 hours or less.

The heat treatment for sintering the obtained oxysulfide is performed, for example, in a pressurized atmosphere of an inert gas. The heat treatment temperature is, for example, 1000°C or more and 2000°C or less. The heat treatment temperature is, for example, 1100°C or more and 1700°C or less. The heat treatment time is, for example, 1 hour or more and 48 hours or less.

The cold storage material of the first embodiment may be, for example, a sintered body of cold storage material particles made of the first cold storage material.

Next, functions and effects of the cold storage material of the first embodiment will be described.

In a cryogenic refrigerator used for cooling a superconducting device or the like, a cold storage material is accommodated in a cold storage device. For example, cold is generated by heat exchange between the cold storage material and helium gas passing through the cold storage device. In order to improve the refrigeration capacity of the refrigerator, the cold storage material accommodated in the cold storage device is required to have excellent characteristics such as high volume specific heat and high thermal conductivity.

An upper limit of the volume specific heat is limited by the composition of the substance. Therefore, it is difficult to significantly improve the volume specific heat. Meanwhile, the thermal conductivity can be improved by improving crystallinity and reducing the number of voids.

In the cold storage material of the first embodiment, the maximum value of the volume specific heat in the temperature range of 2 K or more and 10 K or less is 0.5 J/(cm³·K) or more. Therefore, the cold storage material of the first embodiment has high volumetric specific heat.

The cold storage material of the first embodiment has, for example, the volume specific heat of 0.5 J/(cm³·K) or more in the temperature range of 2.5 K or more and 10 K or less. In addition, for example, the volume specific heat in the temperature range of 2 K or more and 8 K or less is 0.55 J/(cm³·K) or more. In addition, for example, the volume specific heat in the temperature range of 4 K or more and 7 K or less is 0.6 J/(cm³·K) or more.

As described above, since the cold storage material of the first embodiment has high volume specific heat, the cold storage device accommodating the cold storage material of the first embodiment has high cold storage performance. The refrigerator including the cold storage device in which the cold storage material of the first embodiment is accommodated exhibits high refrigeration capacity.

In addition, the cold storage material of the first embodiment contains the first group element in an atomic concentration of 0.001 atom% or more and 10 atom% or less. The first group element has function of promoting sintering of the molded body and reducing the number of voids of the obtained sintered body in a sintering step when the cold storage material is produced. Therefore, the cold storage material of the first embodiment has a high degree of sintering and a high thermal conductivity.

In order to sufficiently obtain characteristics required for the cold storage material such as the thermal conductivity and volume specific heat, a sufficient sintering temperature and sintering time are required in the sintering process. The cold storage material of the first embodiment makes it possible to lower the sintering temperature required for sintering and to reduce the sintering time by the sintering promoting function of the first group element. Therefore, it is possible to reduce the manufacturing cost of the cold storage material and to provide an inexpensive cold storage material.

When the atomic concentration of the first group element in the cold storage material is 0.001 atom% or more, the degree of sintering increases, and the number of extremely minute voids decreases. Therefore, the thermal conductivity of the cold storage material can increase.

When the atomic concentration of the first group element in the cold storage material exceeds 10 atom%, a sulfide containing a rare earth and the first group element is generated, so that the volume specific heat is lowered and the thermal conductivity is lowered. When the atomic concentration of the first group element in the cold storage material is 10 atom% or less, the volume specific heat is high and the thermal conductivity can be increased, and the refrigeration capacity of the refrigerator containing the cold storage material of the first embodiment is improved.

The first group element contained in the cold storage material of the first embodiment is, for example, at least one element selected from the group consisting of Li, Na, K, Rb, Cs, and Fr. The first group element is preferably at least one element selected from the group consisting of Li, Na, and K. In addition, for example, two or more kinds of the first group elements among the first group elements may be included.

The cold storage material containing the first group element can be produced by using a carbonate, an oxide, a nitride, or a carbide containing the first group element in the raw material powder. The concentration of the first group element contained in the cold storage material is adjusted by adjusting the amount of carbonate, oxide, nitride, or carbide containing the first group element.

The cold storage material of the first embodiment contains, for example, 0 atom% or more and 10 atom% or less in total in terms of atomic concentration of the second group element. In addition, for example, the second group element is contained in a total amount of 0.001 atom% or more and 10 atom% or less in terms of atomic concentration. The second group element is at least one element selected from the group consisting of Be, Mg, Ca, Sr, Ba, and Ra. The atomic concentration of the second group element is, for example, 0.001 atom% or more and 5 atom% or less in total. The cold storage material may contain, for example, two or more kinds of second group elements.

In the cold storage material of the first embodiment, the second group element is contained in an amount of 0.001 atom% or more in addition to the first group element, thereby further improving the sinterability and reducing the number of extremely minute voids. This further improves the thermal conductivity. The second group element does not exhibit specific heat characteristics. Therefore, when the content of the second group element exceeds 10 atom% in total, the volume specific heat as a cold storage material decreases, the cold storage performance of the cold storage device decreases, and the refrigeration capacity of the refrigerator decreases.

By using the carbonate, oxide, nitride, or carbide containing the second group element in the raw material powder, the cold storage material containing the second group element can be produced. The concentration of the second group element contained in the cold storage material is adjusted by adjusting the amount of carbonate, oxide, nitride, or carbide containing the second group element.

When the cold storage material of the first embodiment is produced, by adding 0.01 atom% or more of the sintering aid as a metal or a metalloid element constituting the sintering aid in addition to the first group element, sinterability is further improved, and the number of extremely minute voids is reduced. This further improves the thermal conductivity. The metal or metalloid element constituting the sintering aid does not exhibit specific heat characteristics. Therefore, when the added amount of the metal or metalloid element constituting the sintering aid exceeds 20 atom%, the volume specific heat as the cold storage material decreases, the cold storage performance of the cold storage device decreases, and the refrigeration capacity of the refrigerator decreases.

The cold storage material of the first embodiment preferably contains 0.01 atom% or more and 20 atom% or less of at least one element selected from the group consisting of aluminum (Al), iron (Fe), copper (Cu), nickel (Ni), cobalt (Co), zirconium (Zr), and boron (B). The at least one element selected from the group consisting of Al, Fe, Cu, Ni, Co, Zr, and B is, for example, an element derived from the sintering aid. The at least one element selected from the group consisting of Al, Fe, Cu, Ni, Co, Zr, and B is, for example, an example of a metal or a metalloid element constituting the sintering aid.

As described above, according to the first embodiment, it is possible to realize the cold storage material having excellent characteristics such as high volume specific heat and high thermal conductivity.

### (Second Embodiment)

A cold storage material particle of a second embodiment is formed of the cold storage material of the first embodiment, and has a particle size of 50 um or more and 3 mm or less. An aspect ratio of the cold storage material particle is, for example, 1 or more and 5 or less. The aspect ratio of the cold storage material particle is a ratio of a major axis to a minor axis of the cold storage material particle. A shape of the cold storage material particle is, for example, spherical.

Hereinafter, description of contents overlapping with the first embodiment may be partially omitted.

The particle size of the cold storage material particle is an equivalent circle diameter. The equivalent circle diameter is a diameter of a perfect circle corresponding to an area of a figure observed in an image such as an optical microscope image or a scanning electron microscope image (SEM image). The particle size of the cold storage material particle can be determined, for example, by image analysis of an optical microscope image or an SEM image.

The method for producing the cold storage material particle of the second embodiment is not particularly limited, but for example, the cold storage material particle can be produced by mixing raw material powders using a ball mill or the like to prepare a raw material mixture, molding (granulating) the obtained raw material mixture into particles by a tumbling granulation method, a stirring granulation method, an extrusion method, a spraying method (spray method), a press molding method or the like, and then sintering the obtained granular molded body.

The obtained granular molded body is referred to as granulated particles.

In the granulation method, strength of the granulated particles is improved by adding a binder to adhere the raw material powders to each other. The binder is, for example, polyvinyl alcohol, polyvinyl butyral, carboxymethyl cellulose, an acrylic resin, or polyethylene glycol. The addition amount of the binder is, for example, 0.01 wt% or more and 20 wt% or less.

As the raw material powder, a rare earth oxide or a rare earth oxysulfide can be used. The type and ratio of the rare earth oxide or the rare earth oxysulfide are adjusted in accordance with the target composition of the cold storage material particle.

The cold storage material particles containing the first group element can be produced by using a carbonate containing the first group element, an oxide containing the first group element, a nitride containing the first group element, or a carbide containing the first group element in the raw material powder. In addition, the cold storage material particles containing the second group element can be produced by using a carbonate containing the second group element, an oxide containing the second group element, a nitride containing the second group element, or a carbide containing the second group element in the raw material powder.

By adding a sintering aid to the raw material powder, cold storage material particles containing the sintering aid can be produced. When the sintering aid and the rare earth oxide as a raw material react with each other, an oxide phase containing a rare earth element and a metal or a metalloid element constituting the sintering aid may be formed.

In addition, a slurry prepared by adding a raw material powder to an alginic acid aqueous solution and mixing the raw material powder with the alginic acid aqueous solution may be added dropwise to a gelling solution, and the slurry may be gelled to granulate the slurry into particles. This is a method for granulating particles by causing gelation to proceed by a crosslinking reaction by polyvalent metal ions contained in a gelling solution. Therefore, the strength of the granulated particles, that is, gelation strength varies depending on the amount of alginate contained in the particles.

The amount of alginate contained in the particles can be changed depending on the concentration of alginate contained in the alginic acid aqueous solution or the ratio between the alginic acid aqueous solution and the raw material powder. For dropping the slurry into the gelling solution, for example, a dropper, a burette, a pipette, a syringe, a dispenser, an inkjet, or the like can be used. Hereinafter, the particle granulation method by the same method is referred to as an alginic acid gel method.

In the alginic acid gel method, the particle size and aspect ratio of the particles can be changed by adjusting viscosity of slurry, a diameter of a discharge port at the time of dropping, or the distance between a tip of the discharge port and a liquid level of a gelling solution. The diameter of the discharge port is, for example, 50 um or more and 3000 um or less. The viscosity of the slurry is, for example, 0.1 mPa·s or more and 1,000,000 mPa·s or less. A distance between the tip of the discharge port and the liquid level of the gelling solution is, for example, 0.1 mm or more and 1000 mm or less.

When the dispenser is used for dispensing, any of an air pulse dispenser, a plunger dispenser, and a piezo dispenser may be used as the device.

The inkjet is largely divided into a continuous type and an on-demand type as an ejection method, but any type of ejection method may be used. Further, the on-demand type is divided into three types of a piezo type, a thermal type, and a valve type, but any type may be used.

The slurry dropped on the gelling solution by a dropper, a burette, a pipette, a syringe, a dispenser, an inkjet, or the like is held in the gelling solution to be gelled. By gelling the slurry, granulated particles containing the raw material powder of the cold storage material are formed.

The retention time of the slurry in the gelling solution is, for example, 10 minutes or more and 48 hours or less. When a gelation time is short, gelation does not sufficiently proceed, so that the strength of the granulated particles is smaller than the strength expected from the amount of alginate.

The alginic acid aqueous solution used in the alginic acid gel method is, for example, a sodium alginate aqueous solution, an ammonium alginate aqueous solution, or a potassium alginate aqueous solution. By using a sodium alginate aqueous solution or a potassium alginate aqueous solution containing the first group element, sodium or potassium can be contained in the cold storage material particles. Sodium and potassium can be simultaneously contained by using a mixed aqueous solution of a sodium alginate aqueous solution and a potassium alginate aqueous solution in a slurry.

The concentration of the first group element contained in the particle is adjusted by adjusting the concentration of the alginate containing the first group element. For example, the alginate concentration is 0.01 wt% or more and 5 wt% or less as the alginate aqueous solution. When the concentration of the alginate aqueous solution is lower than 0.01 wt%, a gel having sufficient strength cannot be generated, and particles cannot be obtained.

As the gelling solution, for example, a calcium lactate aqueous solution, a calcium chloride aqueous solution, a manganese (II) chloride aqueous solution, a magnesium sulfate aqueous solution, a beryllium sulfate aqueous solution, a strontium nitrate aqueous solution, a barium chloride aqueous solution, or a barium hydroxide aqueous solution can be used as the aqueous solution containing the second group element.

By using a calcium lactate aqueous solution, a calcium chloride aqueous solution, a magnesium sulfate aqueous solution, a beryllium sulfate aqueous solution, a strontium nitrate aqueous solution, a barium chloride aqueous solution, and a barium hydroxide aqueous solution in a gelling solution, calcium, magnesium, beryllium, strontium, and barium can be contained in the cold storage material particles.

By using an aluminum chloride aqueous solution, an aluminum nitrate aqueous solution, an aluminum lactate aqueous solution, an iron (II) chloride aqueous solution, an iron (III) chloride aqueous solution, a copper (II) chloride aqueous solution, a nickel (II) chloride aqueous solution, or a cobalt (II) chloride aqueous solution as the gelling solution, aluminum, iron, copper, nickel, or cobalt can be contained in the cold storage material particles as a sintering aid.

Since the gelation proceeds by a crosslinking reaction by polyvalent metal ions contained in the gelling solution, when an aqueous solution containing the first group element is used for the slurry and an aqueous solution containing the second group element is used for the gelling solution, the amount of the first group element and the second group element contained in the particles can be adjusted by adjusting an immersion time of the particles that are added dropwise to the gelling solution and granulated in the gelling solution.

At least two kinds of aqueous solutions containing different metal elements selected from the group consisting of a calcium lactate aqueous solution, a calcium chloride aqueous solution, a magnesium sulfate aqueous solution, a beryllium sulfate aqueous solution, a strontium nitrate aqueous solution, a barium chloride aqueous solution, and a barium hydroxide aqueous solution are mixed and used as the gelling solution, whereby two or more kinds of second group elements can be contained in the cold storage material particles.

The particle size of the granulated particles is, for example, 70 um or more and 5 mm or less. The aspect ratio of the granulated particles is, for example, 1 or more and 5 or less.

By degreasing the granulated particles, a certain amount of organic components can be removed. In a case where the raw material is an oxide, when degreasing is insufficient, sulfurization does not sufficiently proceed, and a required amount of oxysulfide cannot be generated. Furthermore, when the degreasing is insufficient and the organic component remains too much, the density of the sintered particles decreases. Therefore, the strength of the cold storage material particle becomes weak, and the cold storage material particle cannot withstand use in a refrigerator.

When the degreasing proceeds too much, the organic component that ensures the strength disappears, so that the strength of the granulated particles after degreasing decreases, and the particles are cracked or chipped. A degreasing temperature is, for example, 400°C or more and 800°C or less, and a time thereof is 30 minutes or more and 12 hours or less.

When a rare earth oxide is used as the raw material powder, the granulated particles are sulfurized. In this case, heat treatment is performed in a sulfurization atmosphere. The sulfurization atmosphere contains, for example, a gas containing a sulfur atom having a negative oxidation number, such as hydrogen sulfide (H₂S), carbon sulfide (CS₂), or methanethiol (CH₃SH). A heat treatment temperature is, for example, 400°C or more and 700°C or less. A heat treatment time is, for example, 1 hour or more and 8 hours or less.

The heat treatment for sintering the oxysulfide particles is performed, for example, in a pressurized atmosphere of an inert gas. The heat treatment temperature is, for example, 1000°C or more and 2000°C or less. The heat treatment temperature is, for example, 1100°C or more and 1700°C or less. The heat treatment time is, for example, 1 hour or more and 48 hours or less.

Next, functions and effects of the cold storage material particle of the second embodiment will be described.

The cold storage material particle of the second embodiment is made of the cold storage material of the first embodiment, and has a particle size of 50 um or more and 3 mm or less. An aspect ratio of the cold storage material particle is, for example, 1 or more and 5 or less. The aspect ratio of the cold storage material particle is a ratio of a major axis to a minor axis of the cold storage material particle. A shape of the cold storage material particle is, for example, spherical.

In the cold storage material particle of the second embodiment, the maximum value of the volume specific heat in the temperature range of 2 K or more and 10 K or less is 0.5 J/(cm³·K) or more. Therefore, the cold storage material particle of the second embodiment has high volume specific heat. Since the cold storage material particle of the second embodiment has high volume specific heat, the cold storage device on which the cold storage material particle of the second embodiment is mounted has high cold storage performance. In addition, the refrigerator including the cold storage device on which the cold storage material particle of the second embodiment is mounted exhibits high refrigeration capacity.

In addition, the cold storage material particle of the second embodiment contains the first group element at an atomic concentration of 0.001 atom% or more and 10 atom% or less. The first group element has function of promoting sintering of the cold storage material particle and reducing the number of voids contained in the cold storage material particle at the time of sintering in producing the cold storage material particle. Therefore, the cold storage material particle has a high degree of sintering and a high thermal conductivity.

In the cold storage material of the first embodiment, the sinterability is further improved by adding 0.01 atom% or more of the sintering aid as a metal or metalloid element constituting the sintering aid in addition to the first group element, and the number of extremely fine voids is reduced. This further improves the thermal conductivity. The metal or metalloid element constituting the sintering aid does not exhibit specific heat characteristics. Therefore, when the added amount of the metal or metalloid element constituting the sintering aid exceeds 20 atom%, the volume specific heat as the cold storage material decreases, the cold storage performance of the cold storage device decreases, and the refrigeration capacity of the refrigerator decreases.

In order to sufficiently obtain characteristics required for the cold storage material particles such as the thermal conductivity and volume specific heat, a sufficient sintering temperature and sintering time are required in the sintering process. The cold storage material particle of the second embodiment makes it possible to lower the sintering temperature required for sintering and to reduce the sintering time by the sintering promoting function of the first group element. Therefore, it is possible to reduce the manufacturing cost of the cold storage material particle and to provide an inexpensive cold storage material particle.

The cold storage material particle according to the second embodiment has the particle size of 50 um or more and 3 mm or less. The particle size of the cold storage material particle is more preferably 1 mm or less, and still more preferably 500 um or less.

When the particle size of the cold storage material particle exceeds the above lower limit value, a packing density of the cold storage material particle in the cold storage device is lowered, a pressure loss of the working medium such as helium is reduced, and refrigeration performance of the refrigerator is improved. Meanwhile, when the particle size of the cold storage material particle is less than the above upper limit value, a distance from a surface of the cold storage material particle to a central portion of the particle is shortened, heat transfer between the working medium and the cold storage material particle is easily transferred to the central portion of the cold storage material, and the refrigeration performance of the refrigerator is improved.

The aspect ratio of the cold storage material particle is preferably 1 or more and 5 or less, and more preferably 1 or more and 2 or less. When the aspect ratio of the cold storage material particle is less than the above upper limit value, the gaps when the cold storage device is filled with the cold storage material particles become uniform, and the refrigeration performance of the refrigerator is improved.

The cold storage material particle of the second embodiment is cracked or chipped during handling when a certain level or more of strength is not satisfied in the degreased granulated particle. When the cold storage material particle deviating from the spherical shape is mounted on the refrigerator, the refrigerator performance decreases, and thus, the granulated particle in which a crack or a chip is generated is discarded as a defective product. For this reason, it is desirable that the granulated particles have a certain level of strength or more in which cracking or chipping does not occur.

The strength of the granulated particles mainly depends on the amount of the binder or the amount of the alginate, but when the amount of these organic components is too large, sulfurization or sintering becomes difficult. Meanwhile, the first group element promotes sintering of the cold storage material particle. When the granulated particles contain the first group element in an atomic concentration of 0.001 atom% or more and 10 atom% or less and further contain a binder or a carbon component derived from alginate in an amount of 0.01 wt% or more and 20 wt% or less, both sinterability and high strength can be achieved by the above two effects.

The content of the carbon component is more preferably 10 wt% or less, still more preferably 5 wt% or less. Even when the first group element is contained at an atomic concentration of 0.001 atom% or more and 10 atom% or less, if the carbon component exceeds 20 wt%, it is difficult to appropriately remove the organic component, or the molding density after degreasing is significantly reduced, and the sintering reaction does not proceed even at a high sintering temperature. For this reason, the strength of the sintered particles is remarkably low, and it is difficult to recover the sintered particles as particles. When the amount of the carbon component is less than 0.01 wt%, the amount of the binder or sodium alginate contained in the granulated particles is small, so that the strength is weakened, and cracking or chipping occurs at the time of handling the granulated particles.

In the degreased granulated particles, when the first group element is contained in an atomic concentration of 0.001 atom% or more and 10 atom% or less, and further the binder or the carbon component derived from alginate is contained in an amount of 0.001 wt% or more and 10 wt% or less, both sinterability and high strength can be achieved. The content of the carbon component is more preferably 5 wt% or less, still more preferably 3 wt% or less. When the carbon component is contained in an amount of more than 10 wt%, since the molding density is low, the density does not increase even after sintering, and strength that can withstand use in a refrigerator is not obtained. When an attempt is made to improve the density after sintering by increasing the sintering temperature, the particles and the particles adhere to each other, and the aspect ratio remarkably decreases.

In consideration of shrinkage due to sintering, the particle size of the granulated particles before and after degreasing is desirably 70 um or more and 5 mm or less. The aspect ratio of the granulated particles before and after degreasing is, for example, 1 or more and 5 or less.

As described above, according to the second embodiment, it is possible to realize a cold storage material particle having excellent characteristics such as high volume specific heat and high thermal conductivity.

### (Third Embodiment)

A cold storage device of the third embodiment is a cold storage device filled with a plurality of cold storage material particles of the second embodiment. In the cold storage device of the third embodiment, for example, the ratio of the cold storage material particles of the second embodiment having the circularity R represented by a formula 4πA/L² less than or equal to 0.5 is 5% or less. "L" is the perimeter of each projection image of the cold storage material particles and "A" is the actual area of the projection image in the formula.

The circularity R can be obtained by performing image processing on the shapes of a plurality of cold storage material particles with an optical microscope. The cold storage material particle having a circularity R of 0.5 or less represents a shape such as presence of irregularities on the surface. When the plurality of cold storage material particles containing such cold storage material particles in an amount of more than 5% fill the cold storage device, a porosity formed by the cold storage material particles in the cold storage device becomes uneven, and filling property becomes unstable. Therefore, when the working medium flows in, the cold storage performance decreases, or the cold storage material particles move or is broken due to stress applied to the cold storage material particles at the time of filling the cold storage material particles or at the time of operating the refrigerator, and fine particles are generated to clog gaps, which causes clogging of gaps, and reduces the refrigeration performance and long-term reliability of the refrigerator. The cold storage material particle having a circularity R of 0.5 or less is preferably 2% or less, and more preferably 0%.

### (Fourth Embodiment)

A refrigerator of the fourth embodiment is a refrigerator including a cold storage device filled with the cold storage material of the first embodiment or a plurality of cold storage material particles of the second embodiment. Hereinafter, description of contents overlapping with the first embodiment, the second embodiment, and the third embodiment will be partially omitted.

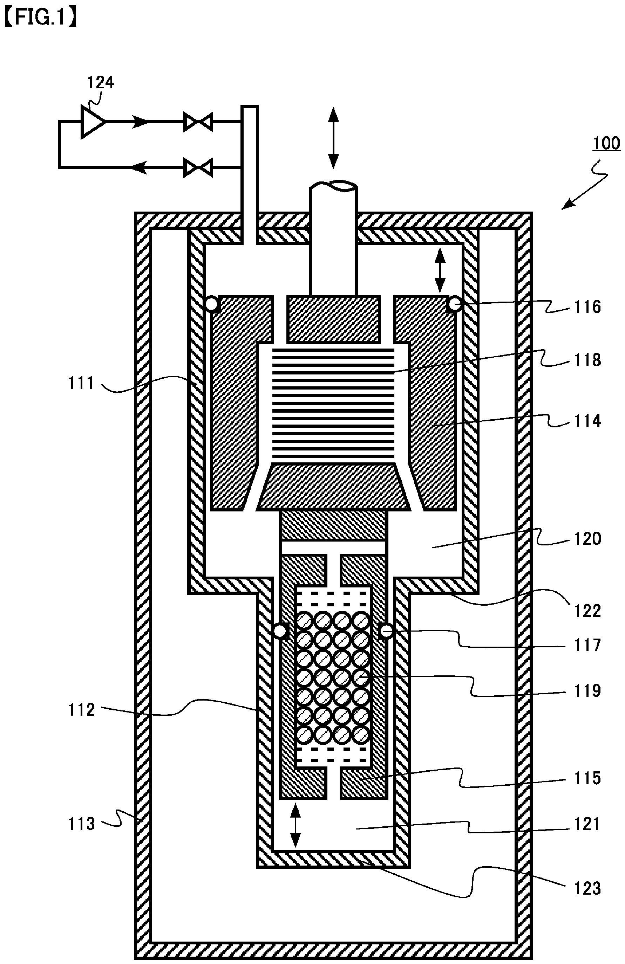

FIG. 1 is a schematic cross-sectional view illustrating a configuration of a main part of the refrigerator of the fourth embodiment including the cold storage device of the third embodiment filled with a plurality of cold storage material particles of the second embodiment. The refrigerator of the fourth embodiment is a two-stage cold storage type cryogenic refrigerator 100 used for cooling a superconducting device or the like.

The cold storage type cryogenic refrigerator 100 includes a first cylinder 111, a second cylinder 112, a vacuum container 113, a first cold storage device 114, a second cold storage device 115, a first seal ring 116, a second seal ring 117, a first cold storage material 118, a second cold storage material 119, a first expansion chamber 120, a second expansion chamber 121, a first cooling stage 122, a second cooling stage 123, and a compressor 124.

The cold storage type cryogenic refrigerator 100 includes the vacuum container 113 in which the large-diameter first cylinder 111 and the small-diameter second cylinder 112 coaxially connected to the first cylinder 111 are installed. The first cold storage device 114 is disposed in the first cylinder 111 so as to be reciprocable. In the second cylinder 112, the second cold storage device 115, which is an example of the cold storage device of the third embodiment, is disposed so as to be reciprocable.

A first seal ring 116 is disposed between the first cylinder 111 and the first cold storage device 114. The second seal ring 117 is disposed between the second cylinder 112 and the second cold storage device 115.

The first cold storage device 114 accommodates the first cold storage material 118 such as a Cu mesh. The second cold storage device 115 accommodates the second cold storage material 119.

The first cold storage device 114 and the second cold storage device 115 each have a working medium passage provided in a gap between the first cold storage material 118 and the second cold storage material 119. The working medium is helium gas.

The first expansion chamber 120 is provided between the first cold storage device 114 and the second cold storage device 115. The second expansion chamber 121 is provided between the second cold storage device 115 and a distal end wall of the second cylinder 112. The first cooling stage 122 is provided at the bottom of the first expansion chamber 120. The second cooling stage 123 having a temperature lower than that of the first cooling stage 122 is formed at the bottom of the second expansion chamber 121.

A high-pressure working medium is supplied from the compressor 124 to the above-described two-stage cold storage type cryogenic refrigerator 100. The supplied working medium passes between the first cold storage materials 118 housed in the first cold storage device 114 and reaches the first expansion chamber 120. Then, the refrigerant passes between the second cold storage materials 119 housed in the second cold storage device 115 and reaches the second expansion chamber 121.

At this time, the working medium is cooled by supplying thermal energy to the first cold storage material 118 and the second cold storage material 119. The working medium passing between the first cold storage material 118 and the second cold storage material 119 expands in the first expansion chamber 120 and the second expansion chamber 121 to generate cold. Then, the first cooling stage 122 and the second cooling stage 123 are cooled.

The expanded working medium flows in the opposite direction between the first cold storage material 118 and the second cold storage material 119. The working medium is discharged after receiving thermal energy from the first cold storage material 118 and the second cold storage material 119. The cold storage type cryogenic refrigerator 100 is configured such that the thermal efficiency of the working medium cycle is improved as the recuperating effect is improved in such a process, and a lower temperature is realized.

The cold storage device included in the refrigerator of the fourth embodiment accommodates the cold storage material of the first embodiment in the second cold storage device 115 as at least a part of the second cold storage material 119. The second cold storage device 115 may be filled with a plurality of the cold storage material particles of the second embodiment as at least a part of the second cold storage material 119. In the plurality of cold storage material particles of the second embodiment, it is preferable that the ratio of the particles having the circularity R represented by a formula 4πA/L² less than or equal to 0.5 is 5% or less. "L" is the perimeter of each projection image of the cold storage material particles and "A" is the actual area of the projection image in the formula.

In the fourth embodiment, the cold storage device of the third embodiment may include, for example, a plurality of cold storage material filling layers of different types of cold storage materials. The different types of cold storage materials may be divided by a mesh. The mesh is, for example, a metal mesh. At least one of the plurality of cold storage material filling layers is the cold storage material of the first embodiment or the cold storage material particle of the second embodiment. In the refrigerator of the fourth embodiment, for example, the cold storage material of the first embodiment or the plurality of cold storage material particles of the second embodiments fill the cold storage device on the low temperature side.

In order to improve the refrigeration capacity of the refrigerator, it is desirable to improve the specific heat per unit volume of the cold storage material and to improve the thermal conductivity. The refrigerator according to the fourth embodiment includes the cold storage material or cold storage material particles which maintain the volume specific heat and have improved thermal conductivity.

For example, by using the refrigerator of the fourth embodiment in a magnetically levitated train, the long-term reliability of the magnetically levitated train can be improved.

As described above, according to the fourth embodiment, a refrigerator having excellent characteristics can be realized by using a cold storage material or cold storage material particles having excellent characteristics.

### (Fifth Embodiment)

A cryopump according to a fifth embodiment includes the refrigerator according to the fourth embodiment. Hereinafter, description of contents overlapping with the fourth embodiment will be partially omitted.

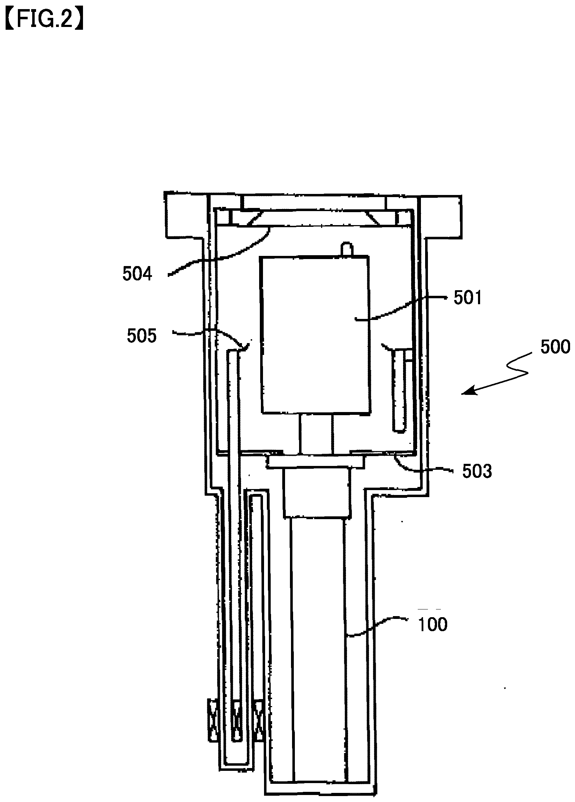

FIG. 2 is a cross-sectional view illustrating a schematic configuration of the cryopump according to the fifth embodiment. The cryopump according to the fifth embodiment is a cryopump 500 including the cold storage type cryogenic refrigerator 100 according to the fourth embodiment.

The cryopump 500 includes a cryopanel 501 that condenses or adsorbs gas molecules, a cold storage type cryogenic refrigerator 100 that cools the cryopanel 501 to a predetermined cryogenic temperature, a shield 503 provided between the cryopanel 501 and the cold storage type cryogenic refrigerator 100, a baffle 504 provided at an intake port, and a ring 505 that changes an exhaust speed of argon, nitrogen, hydrogen, or the like.

According to the fifth embodiment, a cryopump having excellent characteristics can be realized by using a refrigerator having excellent characteristics. By using the cryopump according to the fifth embodiment in a semiconductor manufacturing apparatus, long-term reliability of the semiconductor manufacturing apparatus can be improved.

### (Sixth Embodiment)

A superconducting magnet of the sixth embodiment includes the refrigerator of the fourth embodiment. Hereinafter, description of contents overlapping with the fourth embodiment will be partially omitted.

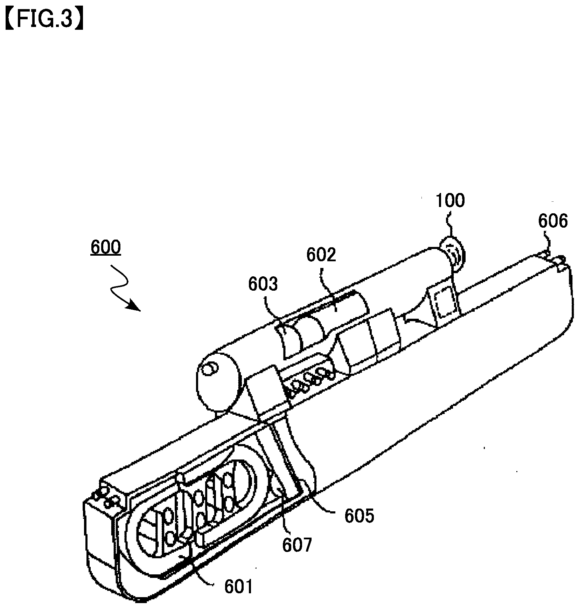

FIG. 3 is a perspective view illustrating a schematic configuration of the superconducting magnet according to the sixth embodiment. The superconducting magnet of the sixth embodiment is, for example, a superconducting magnet 600 for a magnetically levitated train including the cold storage type cryogenic refrigerator 100 of the fourth embodiment.

The superconducting magnet 600 for a magnetically levitated train includes a superconducting coil 601, a liquid helium tank 602 for cooling the superconducting coil 601, a liquid nitrogen tank 603 for preventing volatilization of liquid helium, a laminated heat insulating material 605, a power lead 606, a permanent current switch 607, and a cold storage type cryogenic refrigerator 100.

According to the sixth embodiment, a superconducting magnet having excellent characteristics can be realized by using a refrigerator having excellent characteristics.

### (Seventh Embodiment)

A nuclear magnetic resonance imaging apparatus of a seventh embodiment includes the refrigerator of the fourth embodiment. Hereinafter, description of contents overlapping with the fourth embodiment will be partially omitted.

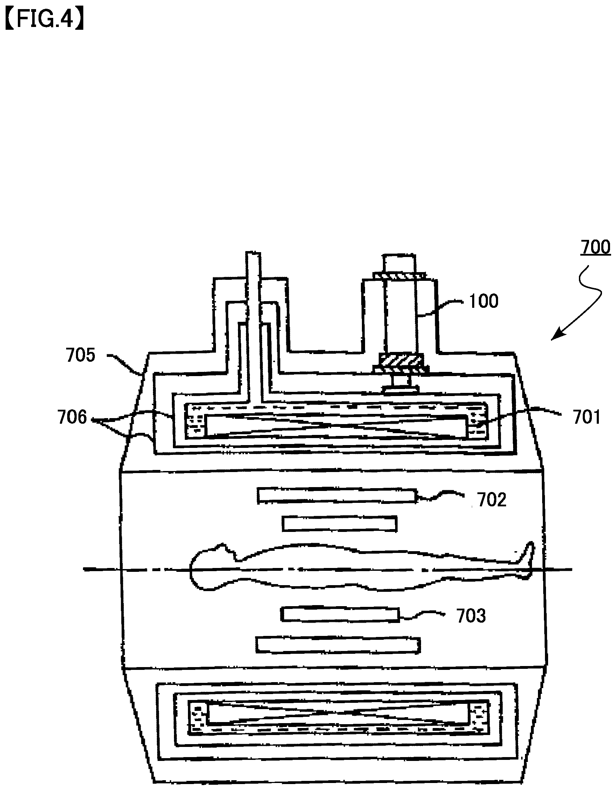

FIG. 4 is a cross-sectional view illustrating a schematic configuration of the nuclear magnetic resonance imaging apparatus of the seventh embodiment. The nuclear magnetic resonance imaging (MRI) apparatus of the seventh embodiment is a nuclear magnetic resonance imaging apparatus 700 including the cold storage type cryogenic refrigerator 100 of the fourth embodiment.

The nuclear magnetic resonance imaging apparatus 700 includes a superconducting static magnetic field coil 701 that applies a spatially uniform and temporally stable static magnetic field to a human body, a correction coil (not illustrated) that corrects nonuniformity of a generated magnetic field, a gradient magnetic field coil 702 that gives a magnetic field gradient to a measurement region, a radio wave transmission/reception probe 703, a cryostat 705, and a radiation adiabatic shield 706. The cold storage type cryogenic refrigerator 100 is used for cooling the superconducting static magnetic field coil 701.

According to the seventh embodiment, a nuclear magnetic resonance imaging apparatus having excellent characteristics can be realized by using a refrigerator having excellent characteristics.

### (Eighth Embodiment)

The nuclear magnetic resonance apparatus of an eighth embodiment includes the refrigerator of the fourth embodiment. Hereinafter, description of contents overlapping with the fourth embodiment will be partially omitted.

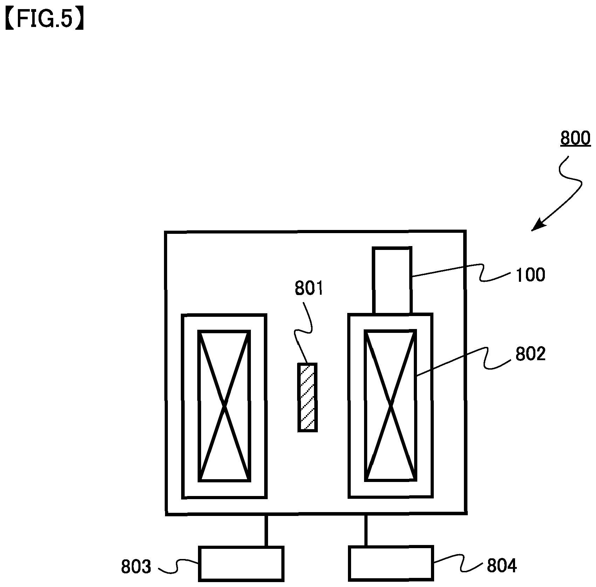

FIG. 5 is a cross-sectional view illustrating a schematic configuration of the nuclear magnetic resonance apparatus of the eighth embodiment. The nuclear magnetic resonance (NMR) apparatus of the eighth embodiment is a nuclear magnetic resonance apparatus 800 including the cold storage type cryogenic refrigerator 100 of the fourth embodiment.

The nuclear magnetic resonance apparatus 800 includes a superconducting static magnetic field coil 802 that applies a magnetic field to a sample such as an organic substance placed in a sample tube 801, a high frequency oscillator 803 that applies a radio wave to the sample tube 801 in the magnetic field, and an amplifier 804 that amplifies an induced current generated in a coil (not illustrated) around the sample tube 801. In addition, the cold storage type cryogenic refrigerator 100 that cools the superconducting static magnetic field coil 802 is provided.

According to the eighth embodiment, a nuclear magnetic resonance apparatus having excellent characteristics can be realized by using a refrigerator having excellent characteristics.

### (Ninth Embodiment)

A magnetic field application type single crystal pulling apparatus of a ninth embodiment includes the refrigerator of the fourth embodiment. Hereinafter, description of contents overlapping with the fourth embodiment will be partially omitted.

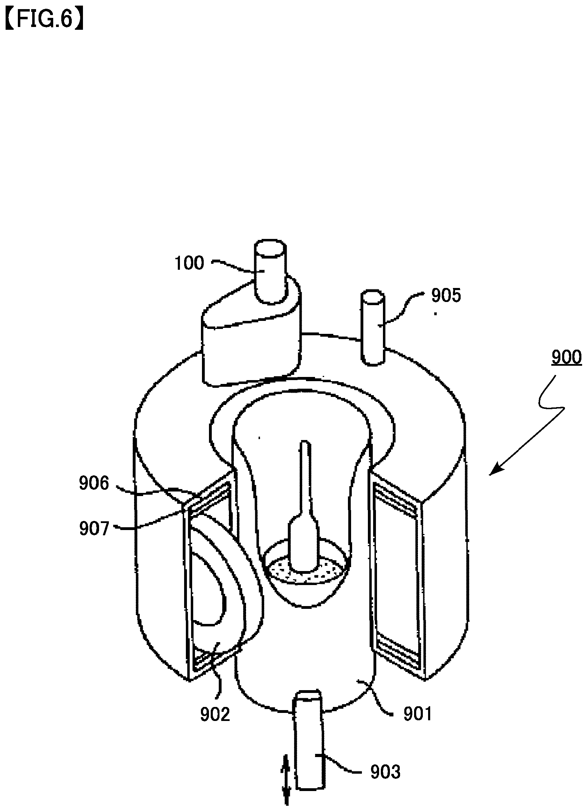

FIG. 6 is a perspective view illustrating a schematic configuration of the magnetic field application type single crystal pulling apparatus according to a ninth embodiment; The magnetic field application type single crystal pulling apparatus of the ninth embodiment is the magnetic field application type single crystal pulling apparatus 900 including the cold storage type cryogenic refrigerator 100 of the fourth embodiment.

The magnetic field application type single crystal pulling apparatus 900 includes a single crystal pulling unit 901 having a raw material melting crucible, a heater, a single crystal pulling mechanism, and the like, a superconducting coil 902 that applies a static magnetic field to the raw material melt, a lifting mechanism 903 of the single crystal pulling unit 901, a current lead 905, a heat shield plate 906, and a helium container 907. The cold storage type cryogenic refrigerator 100 is used for cooling the superconducting coil 902.

According to the ninth embodiment, the magnetic field application type single crystal pulling apparatus having excellent characteristics can be realized by using the refrigerator having excellent characteristics.

### (Tenth Embodiment)

A helium re-condensing device of a tenth embodiment includes the refrigerator of the fourth embodiment. Hereinafter, description of contents overlapping with the fourth embodiment will be partially omitted.

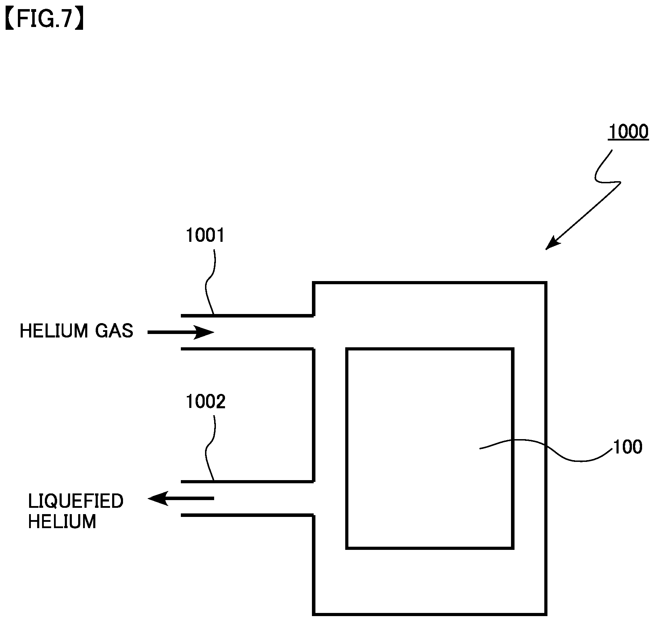

FIG. 7 is a schematic diagram illustrating a schematic configuration of the helium re-condensing device according to the tenth embodiment. The helium re-condensing device of the tenth embodiment is a helium re-condensing device 1000 including the cold storage type cryogenic refrigerator 100 of the fourth embodiment.

The helium re-condensing device 1000 includes the cold storage type cryogenic refrigerator 100, an evaporation pipe 1001, and a liquefaction pipe 1002.

The helium re-condensing device 1000 can recondense helium gas evaporated from a liquid helium device included in a device using liquid helium into liquid helium. The device using liquid helium may be a superconducting magnet, a nuclear magnetic resonance (NMR) device, a nuclear magnetic resonance imaging (MRI) device, a physical property measurement system (PPMS), or a device using a superconducting magnet such as a magnetic property measurement system.

Helium gas is introduced from a liquid helium device (not illustrated) into the helium re-condensing device 1000 through the evaporation pipe 1001. The helium gas is cooled to 4 K equal to or lower than the liquefaction temperature of helium by the cold storage type cryogenic refrigerator 100. The condensed and liquefied liquid helium passes through the liquefaction pipe 1002 and returns to the liquid helium device.

According to the tenth embodiment, a helium re-condensing device having excellent characteristics can be realized by using the refrigerator having excellent characteristics.

### EXAMPLES

Hereinafter, examples, comparative examples, and evaluation results thereof of the cold storage material of the first embodiment and the cold storage material particle of the second embodiment will be described.

### (Example 1)

A Gd₂O₃ powder and a Na₂CO₃ powder were mixed and pulverized in a ball mill for 24 hours to prepare a raw material mixture. Next, the obtained raw material mixture was dried and then granulated using a tumbling granulator to prepare granulated particles having a particle size of 0.3 mm to 0.5 mm. At this time, polyvinyl alcohol was used as a binder, and added in an amount of 1.2 wt% with respect to the raw material powder. The sodium concentration of the granulated particles was 0.52 atom%, and the carbon concentration was 0.99 wt%. The obtained raw material mixture was molded to obtain a molded body.

In order to evaluate the strength of the granulated particles, a cylindrical container having a diameter of 15 mm and a height of 5 mm was filled with the granulated particles. At this time, the cylindrical container was filled with the cold storage materials of a sufficient amount so that the granulated particles were fixed in the cylindrical container and did not move freely. A single vibration having an amplitude of 2 mm and a maximum acceleration of 200 m/s² was applied to the container 1 × 10³ times. As a result, the ratio of the broken cold storage material was less than 0.1 wt%.

The granulated particles and the molded body were degreased at 600°C for 6 hours in the air atmosphere. The degreased granulated particles and the molded body had a sodium concentration of 0.54 atom% and a carbon concentration of 0.51 wt%. A heat treatment was performed at 500°C for 4 hours in an atmosphere containing hydrogen sulfide (H₂S) to sulfurize the particles and the molded body. A heat treatment was performed at 1300°C for 12 hours in an inert gas pressurized atmosphere to sinter the particles and the molded body.

The main constituent elements of the cold storage material and the cold storage material particle of Example 1 are gadolinium oxysulfide. The concentration of sodium in the cold storage material and the cold storage material particles of Example 1 was 0.55 atom%.

The maximum value of the volume specific heat at 10 K or less and the thermal conductivity at 4.2 K of the cold storage material according to Example 1 were measured. The measurement was performed using a physical property measurement system (PPMS).

250 g of the cold storage material particle according to Example 1 was filled into a low-temperature side of a second-stage cold storage device of the two-stage GM refrigerator illustrated in FIG. 1, while 250 g of the Pb cold storage material was filled into a high-temperature side, the refrigerator according to Example 1 was assembled, and a refrigeration test was performed to measure the refrigeration capacity at 4.2 K. In a first-stage cold storage device, a thermal load was applied so that the temperature was 50 K.

As a result of the refrigeration test, 0.66 W was obtained as the refrigeration capacity at 4.2 K.

In the following Examples and Comparative Examples, the mixing time of the raw material powders, the conditions of the sulfurization heat treatment, the conditions of the sintering heat treatment, and the like are adjusted to be appropriate conditions. In addition, the test conditions of the refrigerator were set to be the same.

### (Example 2)

A cold storage material and cold storage material particles were produced in the same manner as in Example 1 except that a Li₂CO₃ powder was used instead of the Na₂CO₃ powder.

### (Example 3)

A cold storage material and cold storage material particles were produced in the same manner as in Example 1 except that a K₂CO₃ powder was used instead of the Na₂CO₃ powder.

### (Example 4)

A cold storage material and cold storage material particles were produced in the same manner as in Example 1 except that CaCOs powder was used in addition to Na₂CO₃ powder.

### (Example 5)

A cold storage material and cold storage material particles were produced in the same manner as in Example 4 except that a Li₂CO₃ powder was used instead of the Na₂CO₃ powder.

### (Example 6)

A cold storage material and cold storage material particles were produced in the same manner as in Example 4 except that a K₂CO₃ powder was used instead of the Na₂CO₃ powder.

### (Example 7)

A cold storage material and cold storage material particles were produced in the same manner as in Example 4 except that a MgCOs powder was used instead of the CaCOs powder.

### (Example 8)

A cold storage material and cold storage material particles were produced in the same manner as in Example 4 except that a SrCOs powder was used instead of the CaCOs powder.

### (Example 9)

A cold storage material and cold storage material particles were produced in the same manner as in Example 4 except that a BaCOs powder was used instead of the CaCOs powder.

### (Example 10)

A cold storage material and cold storage material particles were produced in the same manner as in Example 1 except that a Gd₂O₂S powder was used instead of the Gd₂O₃ powder.

### (Example 11)

A cold storage material and cold storage material particles were produced in the same manner as in Example 1 except that a Tb₂O₃ powder was used instead of the Gd₂O₃ powder.

### (Example 12)

A cold storage material and cold storage material particles were produced in the same manner as in Example 1 except that a Dy₂O₃ powder was used instead of the Gd₂O₃ powder.

### (Example 13)

A cold storage material and cold storage material particles were produced in the same manner as in Example 1 except that a Ho₂O₃ powder was used instead of the Gd₂O₃ powder.

### (Example 14)

A cold storage material and cold storage material particles were produced in the same manner as in Example 1 except that a K₂CO₃ powder was used in addition to a Na₂CO₃ powder.

### (Example 15)

A cold storage material and cold storage material particles were produced in the same manner as in Example 1 except that a Li₂CO₃ powder was used in addition to a Na₂CO₃ powder.

### (Example 16)

A cold storage material and cold storage material particles were produced in the same manner as in Example 1 except that a K₂CO₃ powder and a CaCOs powder were used in addition to the Na₂CO₃ powder.

### (Example 17)

A cold storage material and cold storage material particles were produced in the same manner as in Example 1 except that a CaCOs powder and a SrCOs powder were used in addition to the Na₂CO₃ powder.

### (Examples 18 to 20)

A cold storage material and cold storage material particles were produced in the same manner as in Example 1 except that the weight of the Na₂CO₃ powder was reduced.

### (Examples 21 to 23)

A cold storage material and cold storage material particles were produced in the same manner as in Example 1 except that the weight of the Na₂CO₃ powder was increased.

### (Examples 24 and 25)

A cold storage material and cold storage material particles were produced in the same manner as in Example 4 except that the weight of the CaCOs powder was reduced.

### (Examples 26 to 28)

A cold storage material and cold storage material particles were produced in the same manner as in Example 4 except that the weight of the CaCOs powder was increased.

### (Examples 29 to 31)

A cold storage material and cold storage material particles were produced in the same manner as in Example 1 except that a part of the Gd₂O₃ powder was changed to Tb₂O₃, Dy₂O₃, or Ho₂O₃.

### (Example 32)

The Gd₂O₃ powder was added to a sodium alginate aqueous solution and mixed for 12 hours to prepare a slurry. The sodium alginate aqueous solution was added so that the amount of sodium alginate was 2.3 wt% with respect to the raw material powder. The prepared slurry was added dropwise to a calcium lactate aqueous solution as a gelling solution. A syringe was used for dropping the slurry. The diameter of the syringe was 510 um, and the distance from the tip of the syringe to the liquid level of the calcium lactate aqueous solution was 100 mm. A mold was filled with the slurry, and then, the slurry was immersed in a gelling solution.

The slurry dropped by the syringe and the slurry filling the mold were held in the gelling solution for 5 hours.

Thereafter, the gelled granulated particles were washed with pure water. The slurry filling the mold was removed from the mold and then washed with pure water to obtain a molded body. After washing the molded body and the particles, the molded body and the particles were dried. The sodium concentration of the granulated particles was 0.78 atom%, and the carbon concentration was 0.82 wt%. After the molded body and the particles were dried, the molded body and the particles were degreased, sulfurized, and sintered.

The degreasing was performed at 600°C for 6 hours in an air atmosphere, and after the degreasing, the sodium concentration of the granulated particles was 1.0 atom%, and the carbon concentration was 0.54 wt%. After the degreasing, heat treatment was performed at 500°C for 4 hours in an atmosphere containing hydrogen sulfide (H₂S) to sulfurize the molded body and the particles. The heat treatment was performed at 1300°C for 12 hours in an inert gas pressurized atmosphere to sinter the molded body and the particles. The main constituent elements of the cold storage material and the cold storage material particle of Example 32 are gadolinium oxysulfide. The sodium concentration in the cold storage material of Example 32 and the cold storage material particles was 0.83 atom%.

### (Example 33)

A cold storage material and cold storage material particles were produced in the same manner as in Example 32 except that a potassium alginate aqueous solution was used instead of the sodium alginate aqueous solution.

### (Examples 34 to 38)

A cold storage material and cold storage material particles were produced in the same manner as in Example 33 except that the amount of the potassium alginate aqueous solution was increased or decreased.

### (Example 39)

A cold storage material and cold storage material particles were produced in the same manner as in Example 32 except that a magnesium chloride aqueous solution was used instead of the calcium lactate aqueous solution.

### (Example 40)

A cold storage material and cold storage material particles were produced in the same manner as in Example 32 except that a strontium chloride aqueous solution was used instead of the calcium lactate aqueous solution.

### (Example 41)

A cold storage material and cold storage material particles were produced in the same manner as in Example 32 except that a barium chloride aqueous solution was used instead of the calcium lactate aqueous solution.

### (Example 42)

A cold storage material and cold storage material particles were produced in the same manner as in Example 32 except that a K₂CO₃ powder was added as a raw material powder.

### (Example 43)

A cold storage material and cold storage material particles were produced in the same manner as in Example 18 except that a Li₂CO₃ powder was added as a raw material powder.

### (Example 44)

A cold storage material and cold storage material particles were produced in the same manner as in Example 32 except that an air pulse dispenser was used instead of a syringe as a method of filling a mold with a slurry and a method of dropping a slurry. The diameter of the nozzle was 510 um, and the distance from the tip of the nozzle to the liquid level of the calcium lactate aqueous solution was 100 mm.

### (Example 45)

A cold storage material and cold storage material particles were produced in the same manner as in Example 32 except that a piezo dispenser was used instead of a syringe as a method of filling a mold with a slurry and a method of dropping a slurry. The diameter of the nozzle was 510 um, and the distance from the tip of the nozzle to the liquid level of the calcium lactate aqueous solution was 100 mm.

### (Examples 46 to 51)

The cold storage material particles of Examples 46 to 51 are different from the cold storage material particle of Example 44 in the particle size or aspect ratio of the cold storage material particle. When the cold storage material particle of Examples 51 to 56 was produced, the diameter of the syringe and the distance from the tip of the syringe to the surface of the gelling solution were changed as compared with the case of producing the cold storage material particle of Example 1.

### (Example 52)

A cold storage material and cold storage material particles were produced in the same manner as in Example 32 except that a continuous type inkjet was used instead of a syringe as a method of filling a mold with a slurry and a method of dropping a slurry. The diameter of the nozzle was 510 um, and the distance from the tip of the nozzle to the liquid level of the calcium lactate aqueous solution was 100 mm.

### (Examples 53 to 56)

A cold storage material and cold storage material particles were produced in the same manner as in Example 1 except that the weight of polyvinyl alcohol was changed. In addition, the strength of the granulated particles was measured in the same manner as in Example 1.

### (Example 57 to 60)

A cold storage material and cold storage material particles were produced in the same manner as in Example 32 except that the amount of sodium alginate with respect to the raw material powder was changed by changing the concentration of the sodium alginate aqueous solution or the ratio of the sodium alginate aqueous solution with respect to the raw material powder. In addition, the strength of the granulated particles was measured in the same manner as in Example 1.

### (Example 61)

A cold storage material and cold storage material particles were produced in the same manner as in Example 1 except that an Al₂O₃ powder was also used as a raw material powder. The Al₂O₃ powder was added so that Al contained in the cold storage material particles was 15 atom%.

### (Example 62)

A cold storage material and cold storage material particles were produced in the same manner as in Example 4 except that an Al₂O₃ powder was also used as a raw material powder. The Al₂O₃ powder was added so that Al contained in the cold storage material particles was 15 atom%.

### (Example 63)

A cold storage material and cold storage material particles were produced in the same manner as in Example 32 except that an aluminum chloride aqueous solution was used instead of the calcium lactate aqueous solution. Al was added so that the amount of Al contained in the cold storage material particles was 0.01 atom%.

### (Example 64)

A cold storage material and cold storage material particles were produced in the same manner as in Example 32 except that an aluminum chloride aqueous solution was used in addition to the calcium lactate aqueous solution. Al was added so that the amount of Al contained in the cold storage material particles was 0.01 atom%.

### (Comparative Example 1)

A cold storage material and a cold storage material particle of Comparative Example 1 are different from the cold storage material and the cold storage material particle of Example 1 in that the atomic concentration of sodium is as low as 0.0008 atom%. When the cold storage material and the cold storage material particle of Comparative Example 1 were produced, the weight of the Na₂CO₃ powder was reduced as compared with the case of producing the cold storage material and the cold storage material particle of Example 1.

### (Comparative Example 2)

A cold storage material and a cold storage material particle of Comparative Example 2 are different from the cold storage material and the cold storage material particle of Example 1 in that the atomic concentration of sodium is as high as 15 atom%. When the cold storage material and the cold storage material particle of Comparative Example 2 were produced, the weight of the Na₂CO₃ powder was increased as compared with the case of producing the cold storage material and the cold storage material particle of Example 1. At this time, NaGdS₂ was remarkably generated in addition to Gd₂O₂S.

### (Comparative Example 3)

A cold storage material and a cold storage material particle of Comparative Example 3 are different from the cold storage material and the cold storage material particle of Example 4 in that the atomic concentration of calcium is as high as 15 atom%. When the cold storage material and the cold storage material particle of Comparative Example 3 were produced, the weight of the CaCOs powder was increased as compared with the case of producing the cold storage material and the cold storage material particle of Example 4.

### (Comparative Example 4)

A cold storage material and a cold storage material particle of Comparative Example 4 are different from the cold storage material and the cold storage material particle of Example 1 in that they do not contain a first group element. The cold storage material and the cold storage material particle of Comparative Example 4 were produced without using a powder containing a first group element.

### (Comparative Example 5)

A cold storage material granulated particles of Comparative Example 5 are different from those of Example 1 in that carbon is as large as 25 wt%. A granulated particles of Comparative Example 5 had a carbon concentration of 12 wt% after degreasing, but the particles after sintering were cracked or chipped, and the particles could not be recovered. For this reason, the evaluation of specific heat and strength and the refrigerator test could not be performed. When the cold storage material and the cold storage material particle of Comparative Example 5 were produced, the weight ratio of polyvinyl alcohol used as a binder was increased to 34 wt% with respect to the raw material powder.

### (Comparative Example 6)

A cold storage material granulated body of Comparative Example 6 is different from that of Example 1 in that carbon is as small as 0.005 wt%. In Comparative Example 6, particles could not be recovered after granulation. For this reason, the evaluation of specific heat and strength and the refrigerator test could not be performed. When the cold storage material and the cold storage material particle of Comparative Example 6 were produced, the weight ratio of polyvinyl alcohol to the raw material powder was 0.2 wt%.

### (Comparative Example 7)

A cold storage material granulated particles after the degreasing treatment in Comparative Example 7 are different from those in Example 1 in that carbon is as large as 15 wt%. The carbon concentration before degreasing is 19 wt%. The granulated particles of Comparative Example 7 were sintered to obtain a cold storage material and cold storage material particles. When the cold storage material and the cold storage material particle of Comparative Example 7 were produced, degreasing was performed at 400°C for 1 hour in the air atmosphere using polyvinyl alcohol in an amount of 24 wt% relative to the raw material powder.

### (Comparative Example 8)

A cold storage material particle after degreasing of Comparative Example 8 is different from that of Example 1 in that carbon is less than or equal to the detection limit. The granulated particles of Comparative Example 8 were cracked or chipped after degreasing. The carbon concentration before degreasing is 0.01 wt%. When the cold storage material and the cold storage material particle of Comparative Example 8 were produced, polyvinyl alcohol was made 0.2 wt% with respect to the raw material powder, and degreasing was performed at 800°C for 12 hours under an air atmosphere.

### (Comparative Example 9)

A cold storage material and a cold storage material particles of Comparative Example 9 are different from those of Example 61 in that Al contained in the cold storage material particles is as large as 25 atom%. When the cold storage material and the cold storage material particle of Comparative Example 9 were produced, the weight of the Al₂O₃ powder was increased as compared with the case of producing the cold storage material and the cold storage material particle of Example 61.

For the cold storage materials according to Examples and Comparative Examples, the maximum value of the volume specific heat at 10 K or less and the thermal conductivity at 4.2 K were measured. The results are illustrated in Table 1, Table 2, and Table 3.

The refrigeration capacity of the cold storage material particle according to each of Examples and Comparative Examples is illustrated in Table 1, Table 2, and Table 3. 250 g of the cold storage material particle according to each of Examples and Comparative Examples was filled into the low-temperature side of the second-stage cold storage device of the two-stage GM refrigerator illustrated in FIG. 1, while 250 g of the Pb cold storage material was filled into the high-temperature side, the refrigerator was assembled, and a refrigeration test was performed to measure the refrigeration capacity at 4.2 K. In a first-stage cold storage device, a thermal load was applied so that the temperature was 50 K.

The evaluation results of the strength of the cold storage material granulated particles before degreasing and after degreasing according to each of Examples and Comparative Examples are illustrated in Table 3. A cylindrical container having a diameter of 15 mm and a height of 5 mm was filled with the granulated particles according to each of Examples and Comparative Examples. At this time, the cylindrical container was filled with the cold storage materials of a sufficient amount so that the granulated particles were fixed in the cylindrical container and did not move freely. A single vibration having an amplitude of 2 mm and a maximum acceleration of 200 m/s² was applied to the container 1 × 10³ times. As a result, the ratio of the broken cold storage material granulated particles was evaluated.

**[Tabl.1]**

| | method | phase of oxysulfide | type of first group element | concentration in particle of first group element (atom %) | type of second group element | concentration in particle of second group element (atom %) | particle size of cold storage material particle (µm) | aspect ratio of cold storage material particle | maximum value of volume specific heat at 10 K or less (J/cm³·K) | thermal conductivity at 4.2K (W/cm·K) | refrigeration capacity at 4.2K (W) |
|---|---|---|---|---|---|---|---|---|---|---|---|
| Example 1 | tumbling granulation | Gd2O2S | Na | 0.55% | | | 250 | 1 | 1.20 | 0.010 | 0.66 |
| Example 2 | tumbling granulation | Gd2O2S | Li | 0.45% | | | 400 | 1 | 1.20 | 0.011 | 0.66 |
| Example 3 | tumbling granulation | Gd2O2S | K | 0.87% | | | 260 | 1 | 1.20 | 0.012 | 0.66 |
| Example 4 | tumbling granulation | Gd2O2S | Na | 0.59% | Ca | 0.004% | 440 | 1.1 | 1.20 | 0.015 | 0.69 |
| Example 5 | tumbling granulation | Gd2O2S | Li | 0.47% | Ca | 0.003% | 220 | 1.2 | 1.20 | 0.014 | 0.68 |
| Example 6 | tumbling granulation | Gd2O2S | K | 0.83% | Ca | 0.005% | 242 | 1.1 | 1.20 | 0.015 | 0.69 |
| Example 7 | tumbling granulation | Gd2O2S | Na | 0.43% | Mg | 0.010% | 360 | 1 | 1.20 | 0.016 | 0.69 |
| Example 8 | tumbling granulation | Gd2O2S | Na | 0.41% | Sr | 0.012% | 460 | 1.5 | 1.20 | 0.016 | 0.69 |
| Example 9 | tumbling granulation | Gd2O2S | Na | 0.47% | Sa | 0.060% | 300 | 1.3 | 1.20 | 0.018 | 0.69 |
| Example 10 | tumbling granulation | Gd2O2S | Na | 1.20% | | | 550 | 1.4 | 1.20 | 0.013 | 0.66 |
| Example 11 | tumbling granulation | Tb2O2S | Na | 0.52% | | | 1000 | 1.6 | 1.75 | 0.010 | 0.62 |
| Example 12 | tumbling granulation | Dy2O2S | Na | 0.51% | | | 50 | 1.1 | 1.00 | 0.010 | 0.61 |
| Example 13 | tumbling granulation | Ho2O2S | Na | 0.55% | | | 450 | 1 | 1.25 | 0.010 | 0.59 |
| Example 14 | tumbling granulation | Gd2O2S | Na | 0.76% | | | 352 | 1 | 1.20 | 0.014 | 0.67 |
| | | | K | 0.82% | | | | | | | |
| Example 15 | tumbling granulation | Gd2O2S | Na | 0.55% | | | 280 | 1.4 | 1.20 | 0.014 | 0.67 |
| | | | Li | 0.61% | | | | | | | |
| Example 16 | tumbling granulation | Gd2O2S | Na | 0.62% | Ca | 0.16% | 421 | 1.2 | 1.20 | 0.180 | 0.71 |
| | | | K | 0.64% | | | | | | | |
| Example 17 | tumbling granulation | Gd2O2S | Na | 0.71% | Ca | 0.15% | 392 | 1.1 | 1.20 | 0.190 | 0.71 |
| | | | | | Sr | 0.12% | | | | | |
| Example 18 | tumbling granulation | Gd2O2S | Na | 0.10% | | | 251 | 1 | 1.20 | 0.009 | 0.66 |
| Example 19 | tumbling granulation | Gd2O2S | Na | 0.01% | | | 250 | 1 | 1.20 | 0.009 | 0.66 |
| Example 20 | tumbling granulation | Gd2O2S | Na | 0.002% | | | 240 | 1 | 1.20 | 0.009 | 0.66 |
| Example 21 | tumbling granulation | Gd2O2S | Na | 1.00% | | | 260 | 1 | 1.00 | 0.015 | 0.69 |
| Example 22 | tumbling granulation | Gd2O2S | Na | 5.00% | | | 250 | 1 | 0.95 | 0.015 | 0.69 |
| Example 23 | tumbling granulation | Gd2O2S | Na | 9.80% | | | 243 | 1 | 0.90 | 0.015 | 0.69 |
| Example 24 | tumbling granulation | Gd2O2S | Na | 0.59% | Ca | 0.003% | 440 | 1.1 | 1.20 | 0.015 | 0.69 |
| Example 25 | tumbling granulation | Gd2O2S | Na | 0.59% | Ca | 0.001% | 430 | 1.1 | 1.20 | 0.015 | 0.69 |
| Example 26 | tumbling granulation | Gd2O2S | Na | 0.59% | Ca | 1.00% | 420 | 1.1 | 1.00 | 0.019 | 0.71 |
| Example 27 | tumbling granulation | Gd2O2S | Na | 0.59% | Ca | 4.90% | 450 | 1.1 | 0.95 | 0.020 | 0.72 |
| Example 28 | tumbling granulation | Gd2O2S | Na | 0.59% | Ca | 9.90% | 440 | 1.1 | 0.90 | 0.021 | 0.73 |
| Example 29 | tumbling granulation | (Gd, Tb)2O2S | Na | 0.55% | | | | 1 | 1.30 | 0.010 | 0.66 |
| Example 30 | tumbling granulation | (Gd. Dy)2O2S | Na | 0.55% | | | | 1 | 1.10 | 0.010 | 0.66 |
| Example 31 | tumbling granulation | (Gd, Ho)2O2S | Na | 0.55% | | | | 1 | 1.10 | 0.010 | 0.66 |

**[Tabl.2]**

| | granulation method | phase of oxysulfide | type of first group element | concentration in particle of first group element (atom %) | type of second group element | concentration in particle of second group element (atom %) | particle size of cold storage material particle (µm) | aspect ratio of cold storage material particle | maximum value of volume specific heat at 10 K or less (J/cm³·K) | thermal conductivity at 4.2K (W/cm·K) | refrigeration capacity at 4.2K (W) |
|---|---|---|---|---|---|---|---|---|---|---|---|
| Example 32 | dropping by syringe | Gd2O2S | Na | 0.83% | Ca | 0.16% | 330 | 1.1 | 1.20 | 0.013 | 0.66 |
| Example 33 | dropping by syringe | Gd2O2S | K | 0.10% | Ca | 0.17% | 280 | 1.2 | 1.20 | 0.014 | 0.67 |
| Example 34 | dropping by syringe | Gd2O2S | K | 0.01% | Ca | 0.17% | 280 | 1.2 | 1.20 | 0.010 | 0.66 |
| Example 35 | dropping by syringe | Gd2O2S | K | 0.002% | Ca | 0.17% | 280 | 1.2 | 1.20 | 0.009 | 0.66 |
| Example 36 | dropping by syringe | Gd2O2S | K | 2.00% | Ca | 0.17% | 280 | 1.2 | 1.10 | 0.015 | 0.69 |
| Example 37 | dropping by syringe | Gd2O2S | K | 5.00% | Ca | 0.17% | 280 | 1.2 | 0.80 | 0.019 | 0.71 |
| Example 38 | dropping by syringe | Gd2O2S | K | 9.90% | Ca | 0.17% | 280 | 1.2 | 0.55 | 0.020 | 0.72 |
| Example 39 | dropping by syringe | Gd2O2S | Na | 0.79% | Mg | 0.21% | 440 | 1 | 1.20 | 0.012 | 0.66 |
| Example 40 | dropping by syringe | Gd2O2S | Na | 0.95% | Sr | 0.91% | 390 | 1.3 | 1.20 | 0.014 | 0.67 |
| Example 41 | dropping by syringe | Gd2O2S | Na | 0.75% | Sa | 0.45% | 380 | 1.2 | 1.20 | 0.014 | 0.67 |
| Example 42 | dropping by syringe | Gd2O2S | Na | 0.77% | Ca | 0.16% | 290 | 1.4 | 1.20 | 0.014 | 0.67 |
| | | | K | 0.81% | | | | | | | |
| Example 43 | dropping by syringe | Gd2O2S | Na | 0.89% | Ca | 0.16% | 452 | 1.1 | 1.20 | 0.014 | 0.67 |
| | | | Li | 1.10% | | | | | | | |
| Example 44 | air pulse dispenser | Gd2O2S | Na | 0.95% | Ca | 0.16% | 352 | 1 | 1.20 | 0.014 | 0.67 |
| Example 45 | piezo dispenser | Gd2O2S | Na | 0.92% | Ca | 0.18% | 256 | 1.1 | 1.20 | 0.014 | 0.67 |
| Example 46 | air pulse dispenser | Gd2O2S | Na | 0.95% | Ca | 0.16% | 50 | 1 | 1.20 | 0.014 | 0.66 |
| Example 47 | air pulse dispenser | Gd2O2S | Na | 0.95% | Ca | 0.16% | 3000 | 1 | 1.20 | 0.014 | 0.66 |
| Example 48 | air pulse dispenser | Gd2O2S | Na | 0.95% | Ca | 0.16% | 40 | 1 | 1.20 | 0.014 | 0.30 |
| Example 49 | air pulse dispenser | Gd2O2S | Na | 0.95% | Ca | 0.16% | 4000 | 1 | 120 | 0.014 | 0.30 |
| Example 50 | air pulse dispenser | Gd2O2S | Na | 0.95% | Ca | 0.16% | 250 | 4.8 | 1.20 | 0.014 | 0.66 |
| Example 51 | air pulse dispenser | Gd2O2S | Na | 0.95% | Ca | 0.16% | 250 | 5.5 | 1.20 | 0.014 | 0.30 |
| Example 52 | continuous type inkjet | Gd2O2S | Na | 0.95% | Ca | 0.16% | 300 | 1 | 1.20 | 0.014 | 0.66 |
| Comparative Example 1 | tumbling granulation | Gd2O2S | Na | 0.0008% | | | 250 | 1 | 120 | 0.005 | 0.40 |
| Comparative Example 2 | tumbling granulation | Gd2O2S | Na | 15.0000% | | | 250 | 1 | 0.40 | 0.010 | 0.30 |
| Comparative Example 3 | tumbling granulation | Gd202S | Na | 0.59% | Ca | 15.0000% | 440 | 1.1 | 0.40 | 0.020 | 0.30 |
| Comparative Example 4 | tumbling granulation | Gd2O2S | - | - | - | - | 440 | 1.1 | 1.20 | 0.004 | 0.40 |

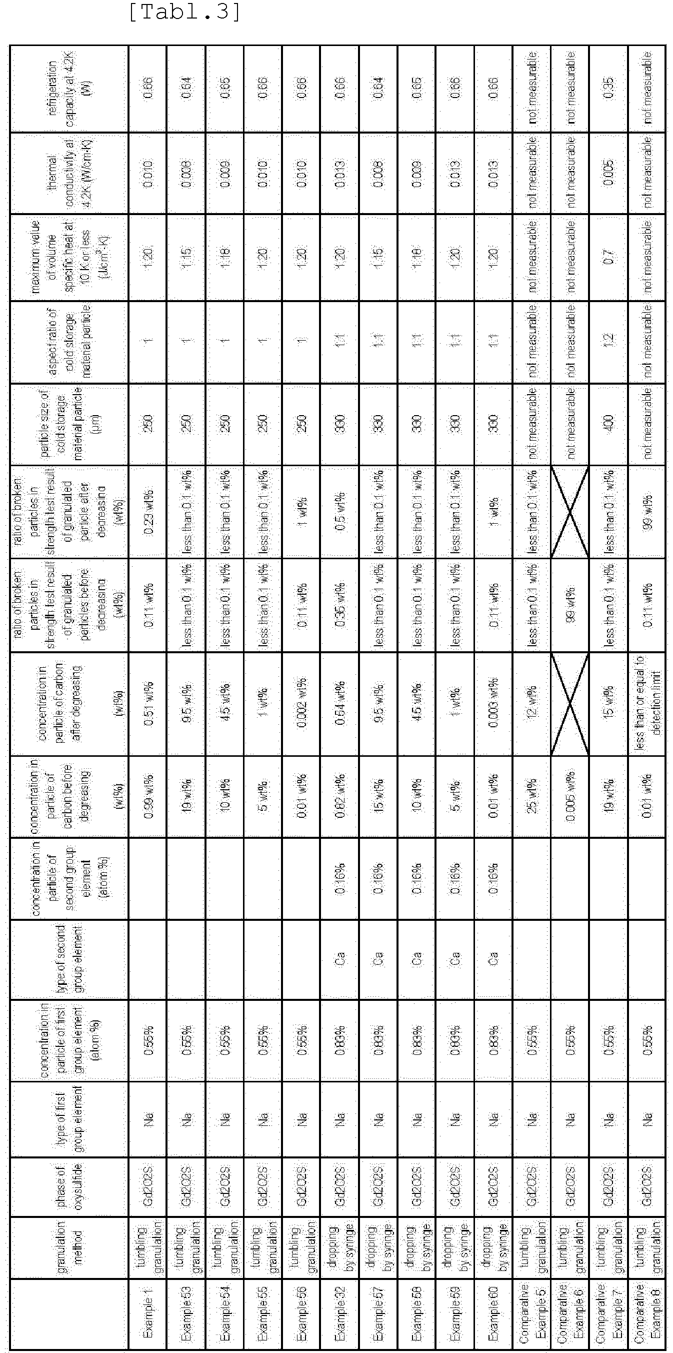

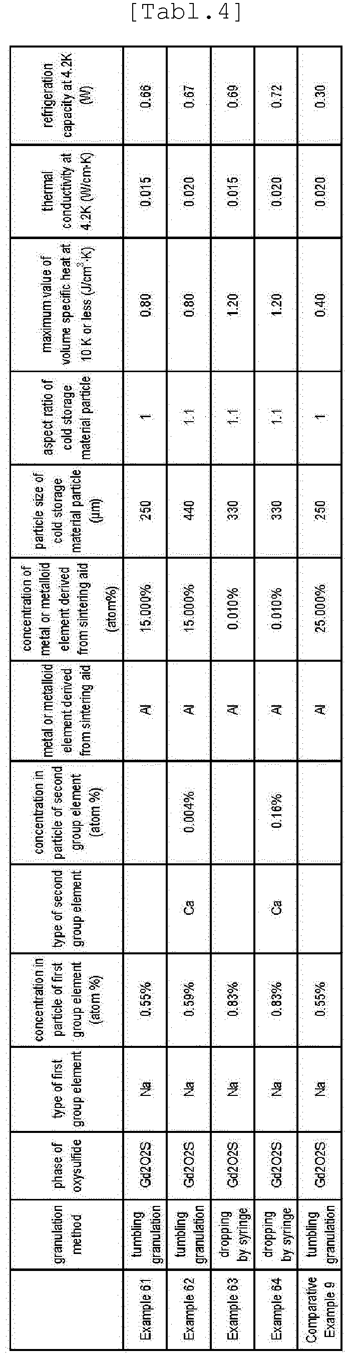

As in Comparative Example 1 and Comparative Example 4, it can be seen that when the atomic concentration of the first group element in the cold storage material is less than 0.001 atom% or the cold storage material does not contain the first group element, the thermal conductivity is as low as 0.005 W/cm·K and 0.004 W/(cm-K). This is considered to be because the sintering promoting effect was reduced due to a decrease in the proportion of the first group element in the cold storage material, and the amount of fine voids was increased.

As in Comparative Example 2, it can be seen that when the atomic concentration of the first group element in the cold storage material is more than 10 atom%, the volume specific heat is as low as 0.4 J/(cm³·K). This is considered to be because the relative amount of the rare earth oxysulfide decreases because the sulfide containing the rare earth and the first group element is generated as the proportion of the first group element in the cold storage material increases.

From the results of Comparative Example 3, when the atomic concentration of the second group element in the cold storage material was more than 10 atom%, the thermal conductivity was increased, but the volume specific heat was as low as 0.4 J/(cm³·K), and the refrigeration capacity using the cold storage material particles was significantly reduced. This is considered to be because the proportion of the rare earth element relatively decreases as the proportion of the second group element in the cold storage material particles increases.

From the results of Tables 1 and 4, the strength is increased by adding the sintering aid so that the metal or metalloid element derived from the sintering aid is 0.01 atom% or more. When the content was more than 20 atom%, the strength was further increased, but the volume specific heat was as low as 0.4 J/(cm³·K), and the refrigeration capacity using the cold storage material particles was significantly reduced. This is considered to be because the proportion of the rare earth element relatively decreases as the proportion of the sintering aid in the cold storage material particles increases.

From Tables 1 and 2, it can be seen that when the particle size of the cold storage material particle falls within the range of 50 µm or more and 3000 µm or less, the refrigeration capacity at 4.2 K is remarkably improved.

Tables 1 and 2 illustrate that when the aspect ratio of the cold storage material particle is 5 or less, the refrigeration capacity at 4.2 K is remarkably improved.

From Tables 1 and 2, it can be seen that even when the method of granulating the cold storage material particles is different, the same particle size, aspect ratio, content of the first and second group elements, and thermal conductivity are exhibited by appropriately adjusting the synthesis conditions.

From Table 1 and Table 2, it can be seen that, even in the case of the cold storage material particles having different granulation methods, the performance and reliability of the refrigerator equipped with the cold storage material particles are equivalent as long as the particle size, the aspect ratio, and the thermal conductivity are equivalent.

Table 3 illustrates that the strength of the granulated particles is high when the granulated particles contain 0.001 atom% or more and 10% or less of the first group element and 0.01 wt% or more and 20 wt% or less of carbon before degreasing. When the carbon concentration is lower than 0.01 wt%, the granulated particles are very fragile and cannot be recovered as particles.

Table 3 illustrates that when the first group element is contained in an amount of 0.001 atom% or more and 10% or less and carbon is contained in an amount of 0.001 wt% or more and 10 wt% or less after degreasing, both the strength and sinterability of the granulated particles can be achieved. In addition, the refrigerator equipped with the obtained cold storage material particles exhibits high refrigeration performance. When the carbon concentration after degreasing exceeds 10 wt%, the strength of the particles is maintained even after degreasing, but since the molding density is low and the sinterability is poor, the density of the particles is low, and the specific heat and the thermal conductivity are low. For this reason, the refrigeration performance at the time of being mounted on the refrigerator is also lowered. When the carbon concentration is lower than 0.001 wt%, the degreased particles are very fragile, and therefore cannot be recovered as particles.

From the above Examples, the effects exhibited by the cold storage material of the first embodiment and the cold storage material particle of the second embodiment were confirmed.

Although the case of an air pulse dispenser or a piezo dispenser has been described as an example of the dispenser, a plunger dispenser may be used.

The case of the continuous type inkjet has been described as an example of the inkjet, but an on-demand type inkjet may be used.

While certain embodiments have been described, these embodiments have been presented by way of example only, and are not intended to limit the scope of the inventions. These embodiments may be embodied in a variety of other forms; furthermore, various omissions, substitutions and changes may be made without departing from the spirit of the inventions. For example, a component of one embodiment may be replaced or changed with a component of another embodiment. These embodiments and modifications thereof are included in the scope and gist of the invention, and are included in the invention described in the claims and the equivalent scope thereof.

### REFERENCE SIGNS LIST

100 Cold storage type cryogenic refrigerator
114, 115 Cold storage device
118, 119 Cold storage material
500 Cryopump
600 Superconducting magnet
700 Nuclear magnetic resonance imaging apparatus
800 Nuclear magnetic resonance apparatus
900 magnetic field application type single crystal pulling apparatus
1000 Helium re-condensing device

## Claims

1. A cold storage material comprising:
a rare earth oxysulfide containing at least one rare earth element selected from the group consisting of Y, La, Ce, Pr, Nd, Sm, Eu, Gd, Tb, Dy, Ho, Er, Tm, Yb, and Lu; and
a first group element of 0.001 atom% or more and 10 atom% or less,
wherein a maximum value of volume specific heat in a temperature range of 2 K or more and 10 K or less is 0.5 J/ (cm³-K) or more.

2. The cold storage material according to claim 1, wherein the first group element is at least one element selected from the group consisting of Li, Na, and K.

3. The cold storage material according to claim 1 or 2, further comprising a second group element of 0 atom% or more and 10 atom% or less.

4. The cold storage material according to claim 1 or 2, further comprising a second group element of 0.001 atom% or more and 10 atom% or less.

5. The cold storage material according to claim 3 or 4, wherein the second group element is at least one element selected from the group consisting of Mg, Ca, Sr, and Ba.

6. The cold storage material according to any one of claims 1 to 5, further comprising 0.01 atom% or more and 20 atom% or less of at least one element selected from the group consisting of Al, Fe, Cu, Ni, Co, Zr, and B.

7. A cold storage material particle formed of the cold storage material according to any one of claims 1 to 6 and having a particle size of 50 µm or more and 3 mm or less.

8. The cold storage material particle according to claim 7, wherein an aspect ratio is 1 or more and 5 or less.

9. A granulated particle to be a raw material of the cold storage material particle according to claim 7 or 8, the granulated particle comprising:
a rare earth oxide containing at least one rare earth element selected from the group consisting of Y, La, Ce, Pr, Nd, Sm, Eu, Gd, Tb, Dy, Ho, Er, Tm, Yb, and Lu, or a rare earth oxysulfide containing at least one rare earth element selected from the group consisting of Y, La, Ce, Pr, Nd, Sm, Eu, Gd, Tb, Dy, Ho, Er, Tm, Yb, and Lu;
a first group element of 0.001 atom% or more and 10 atom% or less; and
carbon of 0.01 wt% or more and 20 wt% or less,
wherein a particle size is 70 µm or more and 5 mm or less, and
an aspect ratio is 1 or more and 5 or less.

10. A degreased granulated particle to be a raw material of the cold storage material particle according to claim 7 or 8, the degreased granulated particle comprising:
a rare earth oxide containing at least one rare earth element selected from the group consisting of Y, La, Ce, Pr, Nd, Sm, Eu, Gd, Tb, Dy, Ho, Er, Tm, Yb, and Lu, or a rare earth oxysulfide containing at least one rare earth element selected from the group consisting of Y, La, Ce, Pr, Nd, Sm, Eu, Gd, Tb, Dy, Ho, Er, Tm, Yb, and Lu;
a first group element of 0.001 atom% or more and 10 atom% or less; and
carbon of 0.001 wt% or more and 10 wt% or less,
wherein a particle size is 70 µm or more and 5 mm or less, and
an aspect ratio is 1 or more and 5 or less.

11. A cold storage device comprising the cold storage material according to any one of claims 1 to 6.

12. A cold storage device filled with a plurality of the cold storage material particles according to claim 7 or 8.

13. A refrigerator comprising the cold storage device according to claim 11 or 12.

14. A cryopump comprising the refrigerator according to claim 13.

15. A superconducting magnet comprising the refrigerator according to claim 13.

16. A nuclear magnetic resonance imaging apparatus comprising the refrigerator according to claim 13.

17. A nuclear magnetic resonance apparatus comprising the refrigerator according to claim 13.

18. A magnetic field application type single crystal pulling apparatus comprising the refrigerator according to claim 13.

19. A helium re-condensing device comprising the refrigerator according to claim 13.
